Europäisches Patentamt

European Patent Office

Office européen des brevets

(19)

(11) EP 0 558 365 B1

(12) FASCICULE DE BREVET EUROPEEN

(45) Date de publication et mention
de la délivrance du brevet:
**02.07.1997 Bulletin 1997/27**

(51) Int Cl.⁶: **H03K 7/06**, G01P 15/08

(21) Numéro de dépôt: **93400316.1**

(22) Date de dépôt: **08.02.1993**

(54) **Dispositif pour la conversion d'une grandeur électrique en un signal électrique dont la fréquence est représentative de ladite grandeur, et capteur utilisant le principe dudit dispositif**

Vorrichtung zur Umwandlung einer elektrischen Grösse in ein elektrisches Signal dessen Frequenz proportional zu der genannten Grösse ist, und die genannte Vorrichtung nutzender Wandler

Device for the conversion of an electric magnitude into an electrical signal which frequency is representative of said magnitude and transducer making use of said device

(84) Etats contractants désignés:
**DE GB**

(30) Priorité: **24.02.1992 FR 9202146**

(43) Date de publication de la demande:
**01.09.1993 Bulletin 1993/35**

(73) Titulaire: **SEXTANT AVIONIQUE**
**F-92366 Meudon la Forêt Cédex (FR)**

(72) Inventeur: **Chevalier, Jean-René**
**F-86100 Chatellerault (FR)**

(74) Mandataire: **de Saint-Palais, Arnaud Marie et al**
**CABINET MOUTARD**
**35, Avenue Victor Hugo**
**78960 Voisins le Bretonneux (FR)**

(56) Documents cités:
**EP-A- 0 221 402**          **EP-A- 0 389 156**
**WO-A-80/00206**

• **PATENT ABSTRACTS OF JAPAN vol. 14, no. 372 (P-1091)(4315) 10 Août 1990 & JP-A-21 38 875**

**Description**

La présente invention concerne un dispositif pour la conversion d'une grandeur électrique, par exemple une tension ou une intensité, en un signal électrique dont la fréquence est représentative de ladite grandeur.

Elle a plus particulièrement pour objet un convertisseur du type comprenant un intégrateur dont le condensateur d'intégration est chargé par un courant électrique représentatif de la grandeur électrique que l'on veut convertir et est déchargé périodiquement par des quantités d'électricité calibrées, déclenchées lorsque la tension à la sortie de l'intégrateur franchit un seuil déterminé.

Ces quantités d'électricité calibrées sont habituellement engendrées par un condensateur de calibrage alternativement relié à une source de courant à tension constante et à l'entrée de l'intégrateur, par l'intermédiaire d'un circuit de commutation commandé par un détecteur de niveau connecté à la sortie de l'intégrateur.

Dans le cas où la tension du courant à mesurer est susceptible de varier de part et d'autre de la valeur de la tension de la source ou, d'une façon équivalente, lorsque ce courant passe d'une valeur positive à une valeur négative, on utilise pour effectuer la connexion entre le condensateur de calibrage et l'entrée de l'intégrateur, un circuit inverseur piloté par un détecteur de signe connecté à la sortie de l'intégrateur.

Le document WO-A-8 000 206 divulgue un dispositif selon le préambule de la revendication 1 et un capteur utilisant un circuit similaire à celui dudit dispositif.

Il s'avère qu'en utilisant un montage inverseur de type classique à six interrupteurs, les charges transférées du condensateur de calibrage au condensateur d'intégration ne sont pas identiques dans un sens et dans l'autre et, qu'en conséquence, le facteur d'échelle du convertisseur est différent selon que le courant à convertir est positif ou négatif. Cette différence est particulièrement notable dans le cas où l'on utilise une technologie CMOS pour la réalisation du circuit de commutation : L'injection de charge dans le sens grille/drain est différente de l'injection de charge dans le sens grille/source.

Il est clair que cette dissymétrie est particulièrement gênante dans le cas où le courant que l'on veut convertir présente une valeur moyenne quasi-nulle.

L'invention a donc plus particulièrement pour but de supprimer cet inconvénient.

Elle propose, à cet effet, un convertisseur du type susdit dans lequel les charges calibrées sont obtenues au moyen de deux circuits de calibrage alimentés à partir de la même source et reliés à l'entrée de l'intégrateur, l'un de ces circuits comprenant un premier condensateur relié à la source par l'intermédiaire d'un premier interrupteur et à l'entrée de l'intégrateur par l'intermédiaire d'un second interrupteur et l'autre circuit de calibragre comprenant un deuxième condensateur de même capacité que le premier, relié à la source par l'intermédiaire d'un amplificateur inverseur en série avec un troisième interrupteur et à l'entrée de l'intégrateur, par l'intermédiaire d'un quatrième interrupteur, la commande des susdits deuxième et quatrième interrupteurs étant assurée par au moins un circuit monostable déclenché par un circuit de détection du niveau de la tension de sortie de l'intégrateur et par un circuit de commutation aiguillant le signal de commande produit par le circuit monostable vers le deuxième ou vers le quatrième interrupteur selon que la tension de sortie de l'intégrateur est positive ou négative : La commande des premier et troisième interrupteurs peut alors s'effectuer de façon synchrone en dehors des périodes d'émission du signal de commande par le circuit monostable.

Avantageusement, le susdit circuit inverseur présente un gain ajustable, réglé de manière à compenser la dissymétrie existant entre les charges des deux condensateurs de calibrage.

Un mode d'exécution de l'invention sera décrit ci-après, à titre d'exemple non limitatif, avec référence aux dessins annexés dans lesquels :

La figure 1 est le schéma synoptique permettant de faire apparaître les inconvénients des convertisseurs connus ;

La figure 2 représente, d'une façon analogue, un convertisseur selon l'invention ;

Les figures 3 et 4 sont des schémas d'un capteur asservi utilisant le principe du convertisseur selon l'invention ;

La figure 5 est le schéma synoptique d'une variante d'exécution du convertisseur selon l'invention.

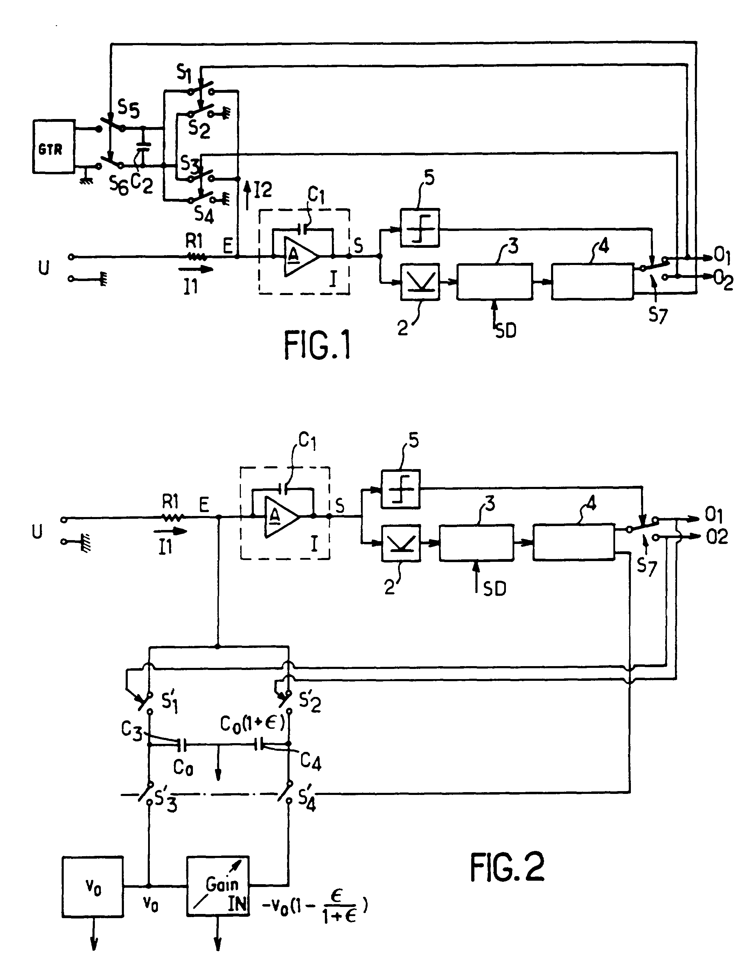

Tel que représenté sur la figure 1, le convertisseur fait intervenir un intégrateur I représenté de façon classique par un amplificateur opérationnel A en parallèle avec un condensateur d'intégration $C_1$. Cet intégrateur I est connecté par son entrée E à une source de tension U à mesurer, par l'intermédiaire d'une résistance $R_1$ et à un condensateur de calibrage $C_2$, par l'intermédiaire d'un circuit inverseur. Dans cet exemple, ce circuit inverseur fait intervenir, de façon classique, deux paires d'interrupteurs $S_1$ à $S_4$, l'une des paires $S_1$, $S_2$ étant destinée à assurer la connexion dans un premier sens, de l'intégrateur I, au condensateur $C_2$, tandis que l'autre paire $S_3$, $S_4$ permet d'effectuer cette connexion en sens inverse.

Le condensateur de calibrage $C_2$ est, quant à lui, relié à une source de courant GTR à tension constante $V_Z$ par l'intermédiaire de deux interrupteurs synchrones $S_5$, $S_6$.

La sortie S de l'intégrateur I est reliée, d'une part, à l'entrée d'un sélecteur $S_7$, par l'intermédiaire d'un circuit comprenant, successivement, un redresseur à double alternance 2, un détecteur de niveau 3 à seuil réglable SD, et un circuit monostable 4 et, d'autre part, à l'entrée de commande du sélecteur $S_7$, par l'intermédiaire d'un détecteur de signe 5.

Le sélecteur $S_7$ a deux sorties $O_1$ et $O_2$ dont l'une, $O_1$, commande la paire d'interrupteurs $S_1$, $S_2$ et l'autre, $O_2$, la paire d'interrupteurs $S_3$, $S_4$.

Le circuit monostable 4 présente une sortie complémentée qui assure la commande simultanée des interrupteurs $S_5$ et $S_6$.

Un cycle de fonctionnement du circuit précédemment décrit comprend l'application d'une charge calibrée à l'entrée E de l'intégrateur I à la suite de la fermeture d'un couple d'interrupteurs $S_1$, $S_2$ ou $S_3$, $S_4$, le sens de cette charge étant déterminé par le détecteur de signe 5 de manière à obtenir une variation de charge dans un premier sens (décharge) du condensateur $C_1$. Suite à la réouverture de la paire d'interrupteurs $S_1$, $S_2$ ou $S_3$, $S_4$ (à la fin de la période métastable du circuit monostable 4), le condensateur $C_1$, alimenté par le courant de la source U, subit une variation de charge en sens inverse, tandis que le couple d'interrupteurs $S_5$, $S_6$ est fermé momentanément de manière à obtenir une recharge du condensateur $C_2$.

Lorsque la valeur absolue de la tension à la sortie de l'intégrateur I atteint le seuil SD, le circuit monostable 4 bascule et provoque le démarrage d'un nouveau cycle de fonctionnement.

La fréquence des créneaux engendrés par le circuit monostable 4 est donc fonction du niveau de tension de la source U que l'on veut convertir.

Comme précédemment mentionné, lorsqu'on réalise le circuit de commutation à l'aide de composants de technologie CMOS, on constate un déséquilibre dans les charges transmises par les couples d'interrupteurs $S_1$, $S_2$ et $S_3$, $S_4$. Ceci est dû au fait que l'injection de charge engendrée par les interrupteurs $S_1$ et $S_2$ est différente de celle émanant des interrupteurs $S_3$ et $S_4$. En fait, on ne décharge pas le condensateur $C_1$ d'une charge de valeur $Q_0 = C_0 V_2$, mais d'une valeur $Q_0 \pm \varepsilon_1$ dans un cas, et $Q_0 \pm \varepsilon_2$ dans l'autre cas. Le facteur d'échelle du convertisseur n'est donc pas le même selon que le courant provenant de la source U est positif ou négatif.

Dans l'exemple représenté sur la figure 2, qui décrit un circuit similaire au précédent (dans lequel les mêmes composants portent les mêmes références), cet inconvénient est supprimé grâce à l'emploi d'un circuit de calibrage des impulsions faisant intervenir deux condensateurs de calibrage $C_3$, $C_4$ reliés, d'une part, l'un à l'autre grâce à une jonction portée à la masse et, d'autre part, à l'entrée de l'intégrateur I, par l'intermédiaire de deux interrupteurs respectifs $S'_1$, $S'_2$ pilotés par le circuit sélecteur $S_7$.

La charge de ces deux condensateurs $C_3$, $C_4$ s'effectue au moyen d'une source de courant à tension constante $V_0$ dont l'une des bornes est reliée à la masse, tandis que l'autre borne est reliée au condensateur $C_3$ par l'intermédiaire d'un interrupteur $S'_3$ et au condensateur $C_4$ par l'intermédiaire d'un interrupteur $S'_4$ en série avec un amplificateur inverseur IN à gain variable.

Les capacités des condensateurs de calibrage $C_3$, $C_4$ sont théoriquement identiques. Toutefois, la dissymétrie engendrée par l'injection de charge des interrupteurs $S'_1$, $S'_3$ - $S'_2$, $S'_4$ peut s'assimiler à une dissymétrie des capacités des condensateurs $C_3$, $C_4$ (la capacité du condensateur $C_3$ ayant une valeur $C_0$ et la capacité du condensateur $C_4$ ayant une valeur $C_0 (1 + \varepsilon)$).

Pour compenser cette dissymétrie, on règle le gain G de l'inverseur IN à une valeur :

$$G = -\left(1 - \frac{\varepsilon}{1 + \varepsilon}\right)$$

La charge du condensateur $C_3$ (obtenue par la fermeture de l'interrupteur $S'_3$) sera donc égale à $C_0 V_0$, tandis que la charge du condensateur $C_4$ (obtenue par la fermeture de l'interrupteur $S'_4$) aura pour expression :

$$C_0 (1 + \varepsilon) \times V_0 \left(1 - \frac{\varepsilon}{1 + \varepsilon}\right) = C_0 V_0$$

On constate donc que, grâce à un simple réglage du gain de l'inverseur IN, il devient possible de compenser l'injection de charge des interrupteurs et donc de symétriser les gains de conversion. On rappelle à ce sujet que le facteur d'échelle d'un convertisseur de ce type est inversement proportionnel à une charge :

$$K_{1E} = \frac{1}{Q0}$$

Il s'agit là d'un avantage important auquel s'ajoute le fait que l'on réduit le nombre total d'interrupteurs.

Bien entendu, l'invention peut avoir de multiples applications, similaires à celles des convertisseurs antérieurement connus.

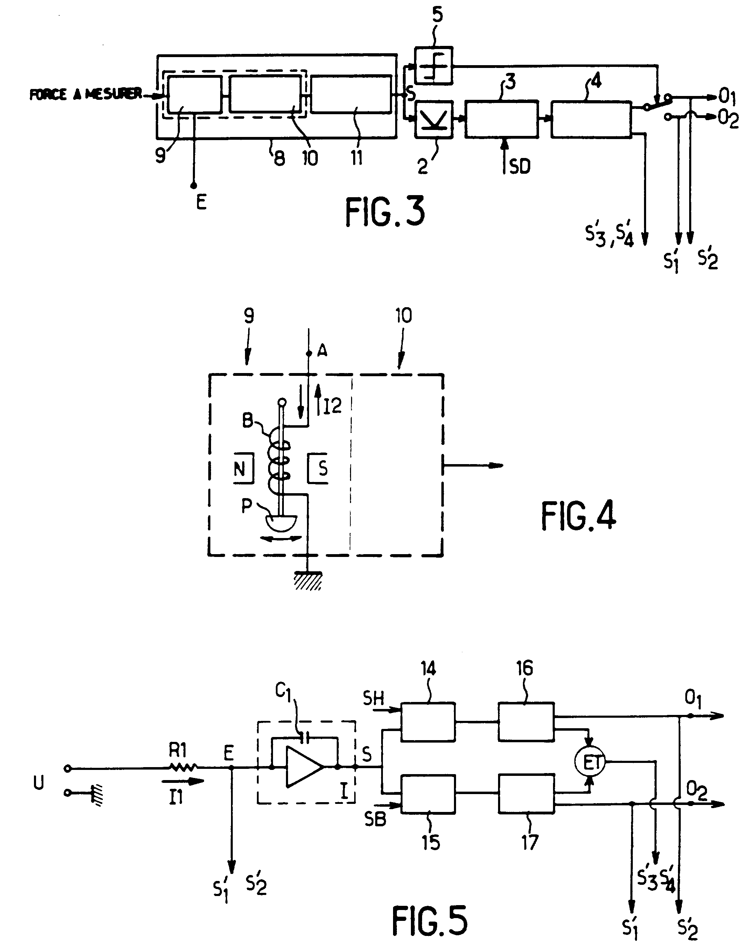

En particulier, le principe général de ce convertisseur peut être utilisé pour réaliser un capteur asservi, du type de celui représenté figures 3 et 4 qui utilise un circuit similaire à celui de la figure 2. Toutefois, l'intégrateur I est, ici, remplacé par un ensemble (bloc 8) comprenant un capteur accélérométrique 9 utilisant un pendule P qui se déplace dans un champ magnétique et dont le mouvement est entretenu grâce à une bobine B qui reçoit l'impulsion calibrée en provenance du condensateur $C_3$ ou du condensateur $C_4$. La position angulaire du pendule P est mesurée par un détecteur d'écart 10 dont la sortie est connectée au point S (qui correspond à la sortie de l'intégrateur I de la figure 2), par l'intermédiaire d'un réseau correcteur 11. Le principe de fonctionnement d'un tel capteur est bien connu.

L'invention ne se limite pas aux modes d'exécution précédemment décrits.

Ainsi, la commande du circuit de commutation associé au condensateur de calibrage pourrait faire intervenir deux détecteurs de niveau 14, 15 connectés au point S, à savoir : un détecteur 14 de niveau haut SH et un détecteur 15 de niveau bas SB, et deux bascules monostables 16, 17 respectivement reliées, par leurs entrées, aux détecteurs de niveau 14, 15 et, par leurs sorties, aux bornes de sortie $O_1$, $O_2$ (qui sont connectées aux bornes de commande des interrupteurs $S'_1$, $S'_2$).

Dans ce cas, le couple d'interrupteurs $S'_3$, $S'_4$ est commandé par une porte ET dont les deux entrées sont respectivement connectées aux sorties complémentées des deux bascules monostables 16, 17.

Un avantage de cette solution consiste en ce qu'il réduit la complexité et le coût du circuit et, qu'en outre, il permet de régler indépendamment le seuil des détecteurs de niveau.

## Revendications

1. Dispositif pour la conversion d'une grandeur physique en un signal électrique dont la fréquence est représentative de cette grandeur, ce dispositif comprenant un intégrateur (I) dont le condensateur d'intégration ($C_1$) est chargé par un courant électrique représentatif de ladite grandeur et est déchargé périodiquement par des quantités d'électricité calibrées par un condensateur ($C_2$), déclenchées lorsque la tension à la sortie de l'intégrateur (I) franchit un seuil déterminé, la liaison entre le condensateur de calibrage ($C_2$) et l'entrée de l'intégrateur (I) comprenant un circuit inverseur piloté en fonction du niveau de sortie de l'intégrateur (I),
caractérisé en ce que les susdites quantités d'électricité calibrées sont obtenues au moyen de deux circuits de calibrage alimentés à partir de la même source de courant ($V_O$), l'un de ces circuits comprenant un premier condensateur ($C_3$) relié à ladite source ($V_O$) par l'intermédiaire d'un premier interrupteur ($S'_3$) et à l'entrée de l'intégrateur (I), par l'intermédiaire d'un second interrupteur ($S'_1$), et l'autre circuit de calibrage comprenant un deuxième condensateur ($C_4$), de même capacité que le premier, relié à la source ($V_0$) par l'intermédiaire d'un amplificateur inverseur (IN) en série avec un troisième interrupteur ($S'_4$) et à l'entrée de l'intégrateur (I) par l'intermédiaire d'un quatrième interrupteur ($S'_2$), la commande des susdits deuxième et quatrième interrupteurs ($S'_1$, $S'_2$) étant assurée par au moins un circuit monostable (4) déclenché par un circuit de détection (2, 3) du niveau de la tension de sortie de l'intégrateur (I).

2. Dispositif selon la revendication 1,
caractérisé en ce que le gain du susdit amplificateur inverseur (IN) est réglé de manière à compenser la dissymétrie existant entre les charges des deux condensateurs de calibrage ($C_3$, $C_4$).

3. Dispositif selon l'une des revendications 1 et 2,
caractérisé en ce que la commande des susdits deuxième et quatrième interrupteurs ($S'_1$, $S'_2$) est assurée par un seul circuit monostable (4) déclenché par un circuit de détection de niveau (3) de la valeur absolue de la tension de sortie de l'intégrateur (I) et par un circuit de commutation (4, $S_7$), aiguillant le signal de commande produit par le circuit monostable (4), vers le deuxième ou vers le quatrième interrupteur ($S'_1$, $S'_2$), selon que la tension de sortie de l'intégrateur (I) est positive ou négative.

4. Dispositif selon l'une des revendications 1 et 2,
caractérisé en ce que la commande du circuit de commutation associé aux condensateurs de calibrage ($C_3$, $C_4$) comprend deux détecteurs de niveau (14, 15) connectés à la sortie de l'intégrateur (I), à savoir : un détecteur (14) de niveau haut (SH) et un détecteur (15) de niveau bas (SB), et deux bascules monostables (16, 17) respectivement reliées, par leurs entrées, aux détecteurs de niveau (14, 15) et, par leurs sorties, aux bornes de commande des susdits deuxième et quatrième interrupteurs (S'$_1$, S'$_2$), les susdits premier et troisième interrupteurs (S'$_3$, S'$_4$) étant commandés de façon synchrone par une porte (ET) dont les deux entrées sont respectivement connectées aux sorties complémentées des deux bascules monostables (16 et 17).

5. Capteur accélérométrique asservi, utilisant un dispositif selon l'une des revendications précédentes, ce dispositif comprenant, à la place du susdit intégrateur (I), un ensemble comportant un détecteur utilisant un pendule (P) mobile dans un champ magnétique et dont le mouvement est entretenu grâce à une bobine (B) recevant les susdites quantités d'électricité calibrées émanant des condensateurs (C$_3$ et C$_4$), la position angulaire de ce pendule (P) étant mesurée par un détecteur d'écart (10) dont le signal de sortie est appliqué au susdit détecteur de niveau (3).

**Patentansprüche**

1. Vorrichtung zur Umwandlung einer physikalischen Größe in ein elektrisches Signal, dessen Frequenz für diese Größe repräsentativ ist, wobei diese Vorrichtung einen Integrator (I) aufweist, dessen Integrationskondensator (C$_1$) mit einem elektrischen Strom geladen wird, der für diese Größe repräsentativ ist, und der durch einen Kondensator (C$_2$) periodisch um kalibrierte elektrische Ladungsmengen entladen wird, die ausgelöst werden, wenn die Spannung am Ausgang des Integrators (I) eine bestimmte Schwelle überschreitet, wobei die Verbindung zwischen dem Kalibrierkondensator (C$_2$) und dem Eingang des Integrators (I) einen Inverter enthält, der in Abhängigkeit vom Ausgangspegel des Integrators (I) gesteuert wird,
dadurch gekennzeichnet, daß die erwähnten kalibrierten elektrischen Ladungsmengen mittels zweiter Kalibrierschaltungen erhalten werden, die von der gleichen Stromquelle (V$_0$) gespeist werden, wobei eine dieser Schaltungen einen ersten Kondensator (C$_3$) aufweist, der über einen ersten Schalter (S'$_3$) mit der Quelle (V$_0$) und über einen zweiten Schalter (S'$_1$) mit dem Eingang des Integrators (I) verbunden ist, und wobei die andere Kalibrierschaltung einen zweiten Kondensator (C$_4$) gleicher Kapazität wie der erste aufweist, der mit der Quelle (V$_0$) über einen Inverter-Verstärker (IN) in Reihe mit einem dritten Schalter (S'$_4$) und mit dem Eingang des Integrators (I) über einen vierten Schalter (S'$_2$) verbunden ist, wobei die Steuerung des zweiten und des vierten Schalters (S'$_1$, S'$_2$) von mindestens einer monostabilen Schaltung (4) gewährleistet wird, die von einer Schaltung (2, 3) zur Erfassung des Pegels der Ausgangsspannung des Integrators (I) ausgelöst wird.

2. Vorrichtung nach Anspruch 1, dadurch gekennzeichnet, daß der Verstärkungsgrad des Inverter-Verstärkers (IN) so geregelt wird, daß er die zwischen den Ladungen der beiden Kalibrierkondensatoren (C$_3$, C$_4$) vorhandene Unsymmetrie kompensiert.

3. Vorrichtung nach einem der Ansprüche 1 und 2, dadurch gekennzeichnet, daß die Steuerung des zweiten und des vierten Schalters (S'$_1$, S'$_2$) von einer einzigen monostabilen Schaltung (4) gewährleistet wird, die von einer Schaltung (3) zur Erfassung des Pegels des Absolutwerts der Ausgangsspannung des Integrators (I) und von einem Schaltkreis (4, S$_7$) ausgelöst wird, der das von der monostabilen Schaltung (4) erzeugte Steuersignal zum zweiten oder zum vierten Schalter (S'$_1$, S'$_2$) leitet, je nachdem, ob die Ausgangsspannung des Integrators (I) positiv oder negativ ist.

4. Vorrichtung nach einem der Ansprüche 1 und 2, dadurch gekennzeichnet, daß die Steuerung des den Kalibrierkondensatoren (C$_3$, C$_4$) zugeordneten Schaltkreises zwei Pegeldetektoren (14, 15), die mit dem Ausgang des Integrators (I) verbunden sind, d.h. einen Detektor (14) für den hohen Pegel (SH) und einen Detektor (15) für der niederen Pegel (SB), und zwei monostabile Kippstufen (16, 17) enthält, die über ihre Eingänge mit den Pegeldetektoren (14, 15) und über ihre Ausgänge mit den Steuerklemmen des zweiten bzw. des vierten Schalters (S'$_1$, S'$_2$) verbunden sind, wobei der erste und der dritte Schalter (S'$_3$, S'$_4$) synchron von einem UND-Tor gesteuert werden, dessen beide Eingänge mit den komplementären Ausgängen der beiden monostabilen Kippstufen (16 und 17) verbunden sind.

5. Geregelter Beschleunigungsmesser, der eine Vorrichtung gemäß einem der vorhergehenden Ansprüche verwendet, wobei diese Vorrichtung anstelle des Integrators (I) eine Einheit aufweist, die einen Detektor enthält, der ein Pendel (P) verwendet, das in einem Magnetfeld beweglich ist und dessen Bewegung mittels einer Spule (B) aufrechterhalten wird, die die von den Kondensatoren (C$_3$ und C$_4$) kommenden kalibrierten elektrischen Ladungsmengen empfängt, wobei die Winkelstellung dieses Pendels (P) von einem Abstandsdetektor (10) gemessen wird, dessen Ausgangssignal an den Pegeldetektor (3) angelegt wird.

**Claims**

1. Device for the conversion of a physical quantity into an electric signal whose frequency is representative of said quantity, said device comprising an integrator (I) whose integration capacitor ($C_1$) is charged by an electric current representative of said quantity and is discharged periodically of quantities of electricity calibrated by a capacitor ($C_2$), said discharges being triggered when the voltage at the output of the integrator (I) exceeds a given threshold, the link between the calibrating capacitor ($C_2$) and the input of the integrator (I) comprising an inverter circuit piloted as a function of the output level of the integrator (I),
characterized in that said calibrated quantities of electricity are obtained by means of two calibrating circuits powered from the same current source ($V_0$), one of these circuits comprising a first capacitor $C_3$ connected to said source ($V_0$) via a first switch ($S'_3$) and to the input of the integrator (I) via a second switch ($S'_1$), and the other calibrating circuit comprising a second capacitor ($C_4$), of the same capacity as the first one, connected to the source ($V_0$) via an inverting amplifier (IN) mounted in series with a third switch ($S'_4$) and to the input of the integrator (I) via a fourth switch ($S'_2$), said second and fourth switches ($S'_1$, $S'_2$) being controlled by at least one monostable circuit (4) triggered by a circuit (2, 3) detecting the level of the output voltage of the integrator (I).

2. Device as claimed in claim 1,
characterized in that the gain of said inverting amplifier (IN) is set so as to compensate the dissymmetry existing between the charges of the two calibrating capacitors ($C_3$, $C_4$).

3. Device as claimed in any one of claims 1 and 2, characterized in that said second and fourth switches ($S'_1$, $S'_2$) are controlled by a single monostable circuit (4) triggered by a circuit (3) detecting the level of the absolute value of the output voltage of the integrator (I) and by a switching circuit (4, $S_7$), switching the control signal produced by the monostable circuit (4) towards the second or fourth switch ($S'_1$, $S'_2$) depending on whether the output voltage of the integrator (I) is positive or negative.

4. Device as claimed in any one of claims 1 and 2, characterized in that the controlling of the switching circuit associated with the calibrating capacitors ($C_3$, $C_4$) comprises two level detectors (14, 15) connected to the output of the integrator (I), i.e. one high-level (SH) detector (14) and one low-level (SB) detector (15), and two monostable flip-flops (16, 17) respectively connected, by their inputs, to the level detectors (14, 15) and, by their outputs, to the control terminals of said second and fourth switches ($S'_1$, $S'_2$), said first and third switches ($S'_3$, $S'_4$) being controlled synchronously by a gate (ET) of which the two inputs are respectively connected to the complemented outputs of the two monostable flip-flops (16, 17).

5. Automatically controlled accelerometric sensor, using a device as claimed in any one of the previous claims, said device comprising, instead of said integrator (I), an assembly comprising a detector using a pendulum (P) which is mobile in a magnetic field and whose motion is maintained by means of a coil (B) which receives said calibrated quantities of electricity coming from the capacitors ($C_3$ or $C_4$), the angular position of this pendulum (P) being measured by a gap detector (10) whose output signal is applied to said level detector (3).

EP 0 558 365 B1

FIG.1

FIG.2

7

FIG.3

FIG.4

FIG.5

8